# EUROPEAN PATENT APPLICATION

(11) **EP 4 800 738 A1**
(43) Date of publication of application: **02.09.2026**
(21) Application number: 24895670.8
(22) Date of filing: 19.07.2024
(51) Int. Cl.: H01J 37/317, H01J 37/30, H01J 37/10, H01L 21/67

(54) **PERIODIC PULSE HIGH-ENERGY ION IMPLANTER**

(30) Priority: 27.11.2023 CN 202311591526
(71) Applicant: Qingdao SRI Intellectual Technology Co., Ltd., Qingdao, Shandong 266000 (CN)
(72) Inventor: NIE, Xiang, Beijing Road, China (Shandong) Pilot Free Trade Zone Qingdao Area Qingdao, Shandong 266000 (CN); CHEN, Xianglong, Beijing Road, China (Shandong) Pilot Free Trade Zone Qingdao Area Qingdao, Shandong 266000 (CN); ZHANG, Hao, Beijing Road, China (Shandong) Pilot Free Trade Zone Qingdao Area Qingdao, Shandong 266000 (CN); WANG, Shusong, Beijing Road, China (Shandong) Pilot Free Trade Zone Qingdao Area Qingdao, Shandong 266000 (CN)
(74) Representative: Bergenstråhle & Partners AB
(86) International application number: PCT/CN2024/106469
(87) International publication number: WO 2025/112567

(57) **Abstract**

Examples of the present disclosure provide a periodic pulsed high-energy ion implanter, and relate to the technical field of semiconductor ion implantation. A specific embodiment of the periodic pulsed high-energy ion implanter includes: a periodic pulsed ion source periodically generates high-density plasma, and an ion beam is extracted by an extraction suppression electrode and a three-dimensional extraction electrode, and is transmitted to a periodic pulsed radio frequency acceleration system after being subjected to mass filtering by a mass analyzer; a pulse period of a radio frequency pulse of the periodic pulsed radio frequency acceleration system is synchronized with a pulse period of an ion source pulse of the periodic pulsed ion source, the ion beam after being subjected to the mass filtering is accelerated to a high-energy state by the periodic pulsed radio frequency acceleration system, and an accelerated ion beam is transmitted to an energy analyzer for being subjected to energy filtering; and the ion beam after being subjected to the energy filtering is expanded in at least one direction by an ion beam scanning device, and a parallel ion beam is generated by a beam collimating lens, and is transmitted to a process chamber, to complete implantation. This embodiment can reduce energy consumption and an area of a machine, and improve ion implantation energy.

## Description

### CROSS-REFERENCE TO RELATED APPLICATIONS

The present disclosure claims the priority to Chinese Application No. CN202311591526.7 filed with the China National Intellectual Property Administration on November 27, 2023 and entitled "Periodic Pulsed High-Energy Ion Implanter", which is incorporated herein in its entirety by reference.

### TECHNICAL FIELD

The present disclosure relates to the technical field of semiconductor ion implantation, and in particular, to a periodic pulsed high-energy ion implanter.

### BACKGROUND OF THE INVENTION

In the manufacturing process of semiconductor elements, an important process is to implant ions into a semiconductor wafer in vacuum, to add impurities to the crystal lattice of the semiconductor wafer. Through this process, the conductivity of the semiconductor wafer is changed. The device used in this process is referred to as an ion implanter. The ion implanter usually ionizes the semiconductor impurity atoms into ions, and accelerates and injects the ions into the semiconductor wafer.

With high integration of semiconductor elements, it is necessary to implant high-energy ions deeper into the semiconductor wafer, and a corresponding device is referred to as a high-energy ion implanter. The high-energy ion implanter usually uses a tandem electrostatic accelerator for ion beam acceleration. With an increase in voltage, the structure of the electrostatic accelerator becomes increasingly complex, and the increasing insulation distance will greatly increase the physical size of the apparatus. In addition, the acceleration voltage is generally lower than 500 KV. For a process requiring high-energy implantation of million electron volts (MeV) , the electrostatic accelerator cannot satisfy energy requirements in different scenarios. Thus, linear accelerators that can accelerate ions to MeV energy (Patent.No.US4667111) based on the principle of radio frequency acceleration are gradually widely used. When a radio frequency acceleration system is adopted in the high-energy ion implanter, various ions generated by an ion source are extracted by an extraction voltage, are filtered by a mass analyzer, and then enter the radio frequency acceleration system. Then, as many ion beams as possible are accelerated to the required energy, and then ions with the required energy are picked out by an energy analyzer, and are scanned and parallelized, and then implanted into the wafer in a process chamber.

In the manufacture of high-quality imaging elements such as a charge-coupled device (CCD), the deeper the ion implantation is, the higher the resolution and sensitivity are. Thus, the demand for ultra-high-energy ion implantation gradually occurs. The existing high-energy ion implanter uses a mode of continuous ion, and can satisfy the requirements of most use scenarios. However, with the ion energy demand exceeding 10 MeV, corresponding energy consumption and floor spaces of machines will become very large. The extremely high energy consumption (typically exceeding 100 kW) of the machines caused brings about the risk of insufficient power supply. In other words, the number of machines that can be accommodated will be greatly reduced under a fixed power supply capacity of a plant.

### BRIEF SUMMARY OF THE INVENTION

In view of this, examples of the present disclosure provide a periodic pulsed high-energy ion implanter, which can solve the problems of high energy consumption and large floor space of a machine, extremely high energy consumption of ion implanter.

To achieve the above objective, the present disclosure provides a periodic pulsed high-energy ion implanter. The periodic pulsed high-energy ion implanter includes:
a periodic pulsed ion source, an extraction suppression electrode, a three-dimensional extraction electrode (that is, three-axis extraction electrode), a mass analyzer, a periodic pulsed radio frequency acceleration system, an energy analyzer, an ion beam scanning device, a beam collimating lens, and a process chamber, where
the periodic pulsed ion source periodically generates high-density plasma, and an ion beam is extracted by the extraction suppression electrode and the three-dimensional extraction electrode, and is transmitted to the periodic pulsed radio frequency acceleration system after being subjected to mass filtering by the mass analyzer; a pulse period of a radio frequency pulse of the periodic pulsed radio frequency acceleration system is synchronized with a pulse period of an ion source pulse of the periodic pulsed ion source, the ion beam after being subjected to the mass filtering is accelerated to a high-energy state by the periodic pulsed radio frequency acceleration system, and an accelerated ion beam is transmitted to the energy analyzer for being subjected to energy filtering; and the ion beam after being subjected to the energy filtering is expanded in at least one direction by the ion beam scanning device, and a parallel ion beam is generated by the beam collimating lens, and is transmitted to the process chamber, to complete implantation.

According to one or more technical solutions provided in the examples of the present disclosure, through the periodic pulsed ion source and the periodic pulsed radio frequency acceleration system that have synchronous pulse periods, the technical effects can be achieved as follows:
(1) By introducing a pulse technology into the high-energy ion implanter, the periodic pulsed high-energy ion implanter with high ion implantation energy, small power consumption and a small area of the machine is provided. Energy consumption of each radio frequency acceleration unit is greatly reduced, the total energy consumption of the machine is reduced, and a cost of the machine is reduced accordingly. In other words, under a same ion implantation energy level, the radio frequency acceleration unit can be reduced, the floor space of the machine can be reduced, and the cost of the machine can be reduced.
(2) Like a traditional high-energy ion implanter, the extraction electrode of the periodic pulsed high-energy ion implanter is a structure closest to the ion source, and can be adjusted along three orthogonal coordinate axis, to optimize a shape and a size of an extracted beam. The extraction suppression electrode is to suppress secondary electrons back-bombard the ion source. The mass analyzer can filter a required ion species and valence state, and its function is unchanged no matter whether the ions arrive continuously or in pulses. The mass analyzer is a large energy-consuming component, but it is difficult to generate pulses with desirable waveforms. Thus, in the periodic pulsed high-energy ion implanter, an extraction suppression power source and the mass analyzer power source still adopt a direct current operating mode.
(3) The ion beam entering the periodic pulsed radio frequency acceleration system presents a pulsed mode, that is, "operating" for a short time and "resting" for a long time. A time span inside the pulse is on the order of hundreds of microseconds, while the radio frequency operating frequency of the radio frequency power source is generally several MHz to tens of MHz. Under the time span corresponding to the radio frequency period (on the order of ten nanoseconds to a hundred nanoseconds), there will be thousands of radio frequency periods inside one pulse, and a time span for the ions to accelerate from keV to MeV is several microseconds. Thus, an operating mode of the radio frequency acceleration system within the pulse has minor differences with an operating mode of a continuous-wave radio frequency acceleration system. The periodic pulsed radio frequency acceleration system includes a plurality of radio frequency acceleration units. On the premise of pulse synchronization, the radio frequency power sources need to implement phase locking at the same frequency in the pulse and can accurately implement appointed phase shift.
(4) RF (Radio Frequency) voltage of the radio frequency power source is sinusoidal, and an inductance L and a capacitance C in the radio frequency acceleration unit are large. If the ion beam arrives during the process of establishment and dissipation of resonance of the inductance L and the capacitance C, an expected acceleration effect cannot be achieved. Thus, a pulse delay technology is used to ensure that most ions arrive in a flat top area of the radio frequency pulse, to achieve the expected acceleration effect. In a microwave cavity of an analogous electron accelerator, an equivalent inductance L and an equivalent capacitance C are small, and establishment time and dissipation time of the resonance energy balance can be reduced to the order of hundreds of nanoseconds under the pulse operating method. That is, the higher the frequency is, the shorter the establishment and dissipation time of the energy balance in the radio frequency acceleration unit is. Thus, a high radio frequency operating frequency of the radio frequency power source can be selected to shorten the establishment and dissipation time of the energy balance in the radio frequency acceleration unit. Then, a rising edge and a falling edge of the radio frequency pulse are steeper, an ineffective ratio of the pulse width is reduced, and a voltage breakdown threshold is further increased with the pulse period and the pulse width unchanged.
(5) When the pulse is fed into the radio frequency acceleration unit with high power, the rising edge and the falling edge of the pulse are not steep enough due to the high capacitance C and inductance L in the radio frequency acceleration unit. Since the ion beam cannot be fully accelerated at the rising edge and the falling edge of the radio frequency pulse, the present disclosure adopts the method of "pulse nesting", and by adjusting the pulse width of the ion source pulse and the pulse width of the radio frequency pulse, and relative delays of the radio frequency power sources, the ion source pulse is completely nested inside the radio frequency pulse, and located in the flat top area within the radio frequency pulse.
(6) The radio frequency acceleration unit in the periodic pulsed radio frequency acceleration system has the same structure as the radio frequency acceleration unit in the continuous-wave radio frequency acceleration system, and an acceleration voltage can reach about 90 kV in the continuous wave mode. However, in the periodic pulsed mode, if the radio frequency pulse duty ratio is 1% to 10%, an acceleration voltage inside the pulse can reach about 180 kV to 270 kV. The risk of electrical breakdown is reduced, and the ion acceleration energy is improved. The same number of radio frequency acceleration units can achieve 2 to 3 times the acceleration energy when connected in series. A total power of the traditional continuous-wave high-energy ion implanter is 30 kW to 100 kW. If the pulsed mode is adopted, the radio frequency pulse duty ratio is 10%, and the power of the periodic pulsed radio frequency acceleration system will be one tenth of the power of the continuous-wave radio frequency acceleration system. Thus, the same ion implantation energy can be achieved when a total power of the periodic pulsed high-energy ion implanter is 10 kW to 20 kW, and the power demand for a factory building is greatly reduced.
(7) Since an average ion beam current and an ion implantation dose can reach expected levels only if the beam current inside the pulse is large, it will be more difficult for transverse focusing of the ion beam current in a long and narrow radio frequency acceleration channel. A conventional continuous-wave electrostatic quadrupole lens also has the problem of a withstand voltage, and the voltage cannot be too high, resulting in limited transverse focusing capability. In a scenario where the beam inside the pulse is large, the periodic pulsed method is adopted, the electrode structure of the quadrupole lens is not changed, and the electrical breakdown threshold is increased by several times. Thus, a withstand voltage capability can be improved, and the voltage and transverse focusing capability within the pulse can be improved.

### BRIEF DESCRIPTION OF DRAWINGS

More details, features, and advantages of the present disclosure will be disclosed in the following description of illustrative examples made in conjunction with the accompanying drawings. In the figures:
FIG. 1 shows a schematic diagram of a periodic pulsed high-energy ion implanter according to an illustrative example of the present disclosure;
FIG. 2 shows a schematic diagram of a periodic pulsed radio frequency acceleration system according to an illustrative example of the present disclosure;
FIG. 3 shows a schematic diagram of a signal waveform of a radio frequency sinusoidal voltage generated by a radio frequency power source according to an illustrative example of the present disclosure;
FIG. 4 shows a schematic diagram of an envelope relationship between ion source pulse and a radio frequency pulse according to an illustrative example of the present disclosure;
FIG. 5 shows a schematic diagram of synchronization of an operating pulse width and a scanning period according to an illustrative example of the present disclosure; and
FIG. 6 shows a schematic diagram of energy consumption comparison between a continuous-wave high-energy ion implanter and a periodic pulsed high-energy ion implanter according to an illustrative example of the present disclosure.

### DETAILED DESCRIPTION OF THE EMBODIMENTS

The examples of the present disclosure will be described below in more detail with reference to the accompanying drawings. Although some examples of the present disclosure are shown in the accompanying drawings, it should be understood that the present disclosure can be implemented through various forms and should not be constructed to be limited to the examples expounded herein. On the contrary, these examples are provided for more thorough and complete understanding of the present disclosure. It should be understood that the accompanying drawings and the examples of the present disclosure are merely used for illustration rather than limitation to the protection scope of the present disclosure.

As used herein, the terms "comprise", "include", and their variations are open-ended, that is, "comprise but not limited to" and "include but not limited to". The term "based on" indicates "at least partially based on". The term "in the example of the present disclosure"indicates "at least one example". The term "another illustrative example" indicates "at least another one example". Related definitions of other terms will be given in the following description. It should be noted that concepts such as "first" and "second" mentioned in the present disclosure are merely used to distinguish different devices, modules, or units, rather than limit an order or interdependence of functions performed by these devices, modules or units.

It should be noted that modifications with "a", "an" and "a plurality of" mentioned in the present disclosure are illustrative rather than limitative, and should be understood by those of ordinary skill in the art as "one or more" unless otherwise definitely indicated in the context.

The solution of the present disclosure will be described with reference to the accompanying drawings.

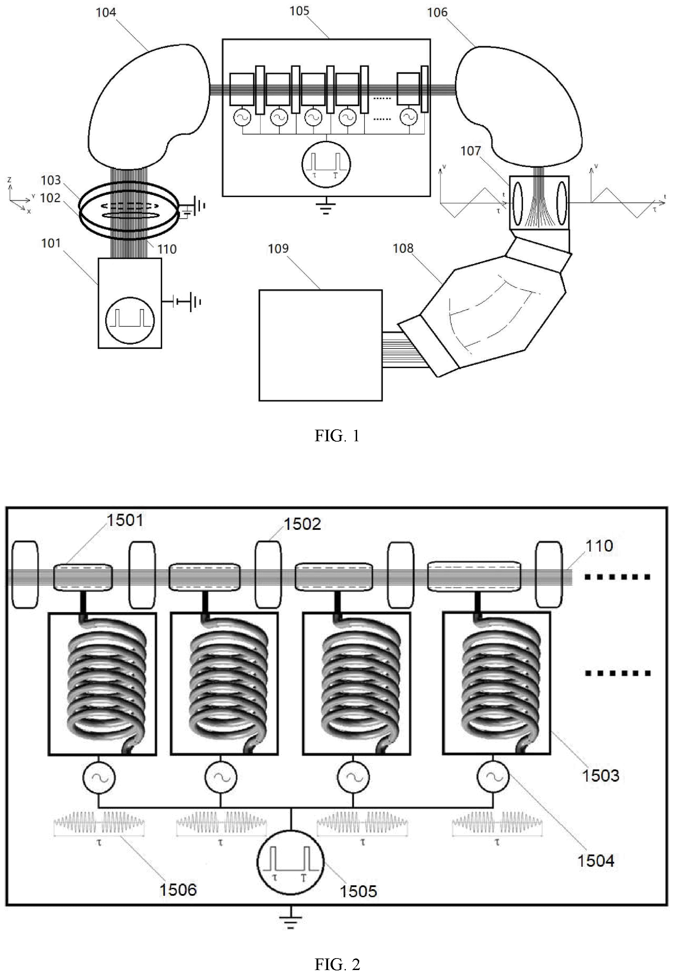

FIG. 1 shows a schematic diagram of a periodic pulsed high-energy ion implanter according to an illustrative example of the present disclosure. As shown in FIG. 1, the periodic pulsed high-energy ion implanter of the present disclosure includes: a periodic pulsed ion source 101, an extraction suppression electrode 102, a three-dimensional extraction electrode 103, a mass analyzer 104, a periodic pulsed radio frequency acceleration system 105, an energy analyzer 106, an ion beam scanning device 107, a beam collimating lens 108, and a process chamber 109.

The periodic pulsed ion source 101 periodically generates high-density plasma, and an ion beam 110 is extracted by the extraction suppression electrode 102 and the three-dimensional extraction electrode 103 is in a pulsed form, and is transmitted to the periodic pulsed radio frequency acceleration system 105 after being subjected to mass filtering by the mass analyzer 104. The periodic pulsed radio frequency acceleration system 105 accelerates the ion beam 110 after being subjected to the mass filtering to a high-energy state. The energy analyzer 106 performs energy filtering on the ion beam 110 accelerated by the periodic pulsed radio frequency acceleration system 105. The ion beam 110 after being subjected to the energy filtering is expanded in at least one direction (for example, an X direction) by the ion beam scanning device 107, and a parallel ion beam is generated by the beam collimating lens 108, and is transmitted to the process chamber 109, to complete implantation. A pulse period of the ion source pulse extracted from the periodic pulsed ion source 101 through the three-dimensional extraction electrode 103 is synchronized with a pulse period of the radio frequency pulse of the periodic pulsed radio frequency acceleration system 105.

Further, different from the continuous-wave operating method, a periodic pulsed operating method enables main components of the high-energy ion implanter, such as the periodic pulsed ion source 101 and the periodic pulsed radio frequency acceleration system 105, to switch periodically between "operating" and "resting" operating states. When in the "operating" state, the ion beam 110 is extracted from the periodic pulsed ion source 101 by the extraction suppression electrode 102 and the three-dimensional extraction electrode 103, and enters the periodic pulsed radio frequency acceleration system 105 after being subjected to the mass filtering by the mass analyzer 104. After being accelerated to the high-energy state, the beam with predetermined energy is filtered by the energy analyzer 106, and then is transmitted to the process chamber 109 through the ion beam scanning device 107 and the beam collimating lens 108, to complete the ion beam implantation. When in the "resting" state, no ions are extracted from the periodic pulsed ion source 101, and the periodic pulsed radio frequency acceleration system 105 "rests" synchronously with the periodic pulsed ion source 101, thus reducing radio frequency energy loss.

Further, the periodic pulsed ion source 101 is maintained at the potential of the extraction voltage through an isolation transformer, and high-density plasma is generated in the interior in a pulsed mode. The ion beam 110 extracted from the ion source by the three-dimensional extraction electrode 103 is a positive ion beam, and the extraction suppression electrode 102 is used to prevent the emitted secondary electrons from back-bombard the ion source. The extraction suppression electrode 102 and the three-dimensional extraction electrode 103 are structurally bound together, and positions in three directions of X, Y, and Z can be adjusted. The mass filtering means that the mass analyzer 104 filters the required ion species from the extracted ion beam 110, and an operating method and design are the same as an operating method and design of the continuous-wave high-energy ion implanter. The structure of a cavity, a radio frequency acceleration unit, and the quadrupole lens of the periodic pulsed radio frequency acceleration system 105 may keep almost unchanged in size compared with those of the continuous-wave high-energy ion implanter. The energy analyzer 106, the ion beam scanning device 107, the beam collimating lens 108, and the process chamber 109 are basically the same as those of the continuous-wave high-energy ion implanter.

In the example of the present disclosure, as shown in FIG. 1, unlike the continuous-wave ion beam extracted by the direct current power source, the periodic pulsed ion source 101 may generate high-density plasma in the pulse, and a plasma density outside the pulse may be rapidly reduced to zero. That is, the periodic pulsed ion source 101 may generate the high-density plasma in the "operating" state, and the plasma density may be rapidly reduced to zero in the "resting" state. Thus, under an extraction effect of the direct current voltage of the three-dimensional extraction electrode 103, the periodic ion source pulses can be generated on a time axis, implementing the periodic extraction of the ion beam.

Further, the periodic pulsed ion source 101 can be implemented by an indirect ion source (also referred to an indirectly heated cathode (IHC) ion source), a microwave ion source, a radio frequency ion source, or a pulsed vacuum arc ion source.

The indirect ion source includes a filament, bias, a source magnetic field, and an arc chamber, etc. A voltage and a current of the filament keep continuous-wave continuous heating, the bias and the source magnetic field also keep a continuous operating method, and the arc chamber voltage adopts a periodic pulse operating method. The periodic ion source pulse is implemented, and a ultra-high transient arc voltage makes a plasma density of the ion beam in the periodic pulse increase instantly.

The microwave ion source includes a microwave amplifier, a microwave seed source, a microwave chamber, etc. A power source of the microwave amplifier adopts a continuous operating method, the microwave seed source adopts a pulse operating method, and the high-density plasma is generated through periodic arcing in the microwave chamber. Thus, the periodic ion source pulse is implemented.

The radio frequency ion source includes a radio frequency power source, a plasma arc chamber, a radio frequency chamber, etc. The radio frequency power source adopts a continuous operating method, and the plasma arc chamber adopts a pulsed operating method, and high-density plasma is generated through periodic arc striking in the radio frequency chamber. Thus, the periodic ion source pulse is implemented.

The pulsed vacuum arc ion source includes a metal cathode, an arcing electrode, etc. The metal cathode maintains a continuous power-on operating method, the arcing electrode applies a periodic pulsed high voltage, and the periodic arcing generates high-density plasma. Thus, the periodic ion source pulse is implemented.

Further, alternatively, a generation method for the periodic ion source pulse may be a combination of the conventional continuous-wave ion source and the three-dimensional extraction electrode 103 that applies the periodic pulse extraction voltage. The higher the extraction voltage is, the higher the extraction current is. In a case that the extraction voltage of the periodic pulse (200 kV) is much higher than the traditional direct current extraction voltage (80 kV), it is still possible to avoid the electric breakdown and increase the ion source beam inside the pulse, The operating method is between the "operating" and "resting" operating states, However, since the plasma density inside the ion source remains unchanged, the extraction current within the pulse does not increase significantly. It should be noted that those of ordinary skill in the art can choose an appropriate generation mode according to an actual production environment as long as the periodic pulsed ion source can be guaranteed to generate the periodic ion source pulse.

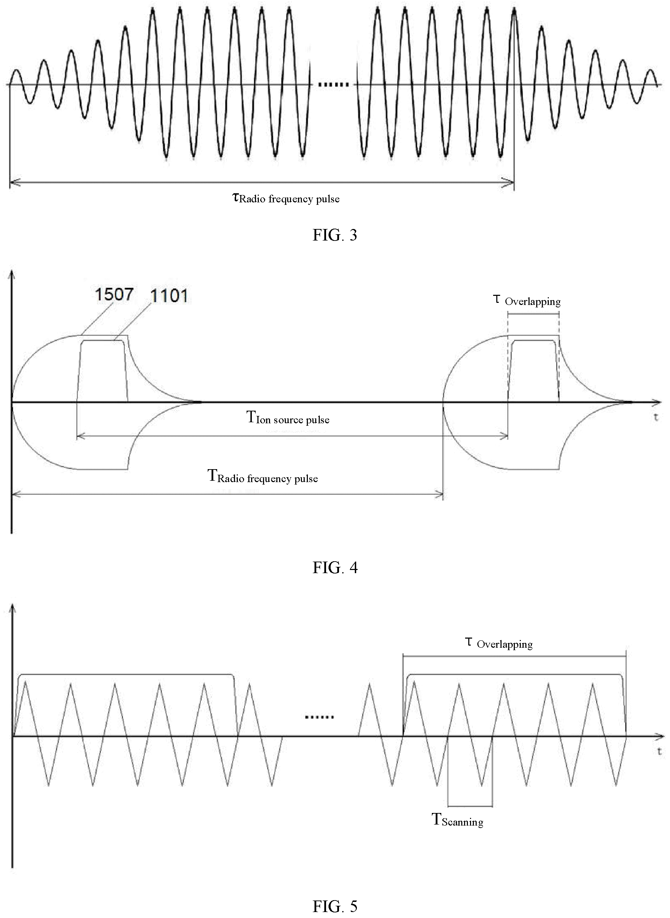

In the example of the present disclosure, as shown in FIG. 2, the periodic pulsed radio frequency acceleration system 105 includes radio frequency acceleration electrodes 1501, quadrupole lenses 1502, radio frequency acceleration units 1503, radio frequency power sources 1504, and a synchronizer 1505. The radio frequency acceleration electrodes 1501, the quadrupole lenses 1502, the radio frequency acceleration units 1503, and the radio frequency power sources 1504 are in one-to-one correspondence, with the number selectively set as required. The synchronizer 1505 controls start and stop of signals of the radio frequency sinusoidal voltages 1506 generated by the radio frequency power sources 1504, and generates periodic radio frequency pulses on the radio frequency acceleration electrodes 1501 through resonant transformation processing by the radio frequency acceleration unit 1503. A waveform of the radio frequency sinusoidal voltage 1506 is shown in FIG. 3.

Further, the radio frequency acceleration unit 1503 adopts a resonant voltage transformation solution, and is internally provided with a high inductance L and a high capacitance C. The radio frequency power source 1504 feeds a radio frequency sinusoidal voltage 1506 to a corresponding radio frequency acceleration unit 1503, and an amplitude of the radio frequency sinusoidal voltage 1506 is modulated through the pulse signal of the synchronizer 1505. Thus, the radio frequency acceleration unit 1503 outputs periodic radio frequency pulses. Since the radio frequency acceleration unit 1503 has long response time (for example, establishment and dissipation time is about 100 *µs*) in a signal start-stop process of the radio frequency sinusoidal voltage 1506. As shown in FIG. 4, when the radio frequency pulse 1507 is generated by the radio frequency acceleration unit 1503, a rising edge and a falling edge of the pulse envelope are obvious (the rising edge and the falling edge indicate that the amplitude envelope of the radio frequency sinusoidal voltage 1506 is not stable), Thus, in order to ensure the expected pulsed energy acceleration, the ion source pulse 1101 of the ion beam 110 extracted by the three-dimensional extraction electrode 103 needs to avoid the rising edge and the falling edge of the radio frequency pulse 1507 at the radio frequency acceleration electrode 1501 in the method of "pulse nesting" as shown in FIG. 4, and the effective ion beam appears at a flat top of the pulse envelope of the radio frequency pulse 1507. With an application scenario as an example, a radio frequency operating frequency *f*_{Radio frequency operating} of the radio frequency power source 1504 is 13.56 MHz, the radio frequency pulse duty ratio η_{Radio frequency pulse} is 4%, the radio frequency pulse frequency *f*_{Radio frequency pulse} (that is, *f*_{Rfp}) of the radio frequency pulse generated by the radio frequency acceleration unit 1503 is 200 Hz, the radio frequency pulse period T_{Radio frequency pulse} is 5 ms, the radio frequency pulse width *τ*_{Radio frequency pulse} is 200 *µs*, and the radio frequency pulse duty ratio *η*_{Radio frequency pulse} is 4% (_{Radio frequency pulse} = *f*_{Radio frequency pulse} × τ_{Radio frequency pulse}). It can be seen that the radio frequency operating frequency *f*_{Radio frequency operating} far exceeds the radio frequency pulse frequency *f*_{Radio frequency pulse}, that is *f*_{Radio frequency operating} » *f*_{Radio frequency pulse}. As shown in FIG. 2, the radio frequency pulse width (abbreviated as the radio frequency pulse width) includes a rising edge _{Radio} frequency pulse and a flat top, that is, the rising edge is about 100 *µs*, the flat top about 100 *µs* is inside the pulse, and the falling edge about 100 *µs* is outside the pulse. The flat top area of the radio frequency pulse width is a available time period of the radio frequency pulse, and the ion source pulse can be effectively accelerated when appearing within this time period. The radio frequency pulse width includes thousands of complete operating periods of the radio frequency operating frequency. Thus, the physical process within the radio frequency pulse width is actually the same as a physical process of the continuous wave.

Further, the pulse period of the ion source pulse extracted from the periodic pulsed ion source 101 through the three-dimensional extraction electrode 103 is synchronized with the pulse period of the radio frequency pulse at the radio frequency acceleration electrode 1501 and the radio frequency acceleration unit 1503. As shown in FIG. 4, the ion source pulse frequency *f*_{Ion source pulse} and the radio frequency pulse frequency *f*_{Radio frequency pulse} of the ion source pulse 1101 and the radio frequency pulse 1507 are the same, that is *f*_{Radio frequency pulse} = *f*_{Ion source pulse}. Correspondingly, the ion source pulse period *T*_{Ion source pulse} of the ion source pulse 1101 and the radio frequency pulse period *T*_{Radio frequency pulse} of the radio frequency pulse 1507 are the same, that is *T*_{Ion source pulse} = *T*_{Radio frequency pulse}. Each ion source pulse width of the ion source pulse 1101 can be completely "nested" in the flat top area of the radio frequency pulse 1507 in a case that the relative delay is precisely adjustable. Thus, for the periodic pulsed high-energy ion implanter, the truly effective operating pulse width is a time period *τ*_{Overlapping} during which the flat top of the radio frequency pulse width *τ*_{Radio frequency pulse} of the radio frequency pulse 1507 overlaps with the ion source pulse width *τ*_{Ion source pulse} of the ion source pulse 1101. The ion source pulse width *τ*_{Ion source pulse} is an available time period of ion source pulse, including a rising edge, a flat top, and a falling edge. Although ion source pulse 1101 also has the rising edge and the falling edge, an acceleration effect is not affected, and a change in the number of ions of acceleration to a particular energy is merely reflected. The rising edge and the falling edge of the radio frequency pulse 1507 may affect the ion acceleration energy, and the ions corresponding to time periods of the rising edge and the falling edge are eventually eliminated by the energy analyzer 106. Thus, the ion beam should be prevented from appearing in this interval.

In the example of the present disclosure, since the pulses of the periodic pulsed ion source 101 and the radio frequency power source 1504 are controllable, the ion source pulse width *τ*_{Ion source pulse} and the radio frequency pulse width *τ*_{Radio frequency pulse} may be selectively set as required, without requiring the periodic pulsed ion source 101 and the periodic pulsed radio frequency acceleration system 105 to start "operating" or "resting" at the same time. That is, the ion source pulse width *τ*_{Ion source pulse} and the radio frequency pulse width may be the same or different. However, the flat top area of the ion τ_{Radio} frequency pulse source pulse width *τ*_{Ion source pulse} and the flat top area of the radio frequency pulse width *τ*_{Radio frequency pulse} need to overlap in time, and a corresponding operating pulse width τ_{Overlapping} is real operating time of the periodic pulsed high-energy ion implanter. Thus, the radio frequency pulse width *τ*_{Radio frequency pulse} is generally larger.

Further, in a case that the ion source pulse width *τ*_{Ion source pulse} and the radio frequency pulse width *τ*_{Radio frequency pulse} are the same, the ion source pulse duty ratio *η*_{Ion source pulse} adopting the "pulse nesting" operating mode is less than or equal to the radio frequency pulse duty ratio *η*_{Radio frequency pulse}, that is:

*η*_{Ion source pulse} ≤ *η*_{Radio frequency pulse}. In the formula,*η*_{Ion source pulse} = *f*_{Ion source pulse} × *τ*_{Ion source pulse}.

Further, an ion source pulse period *T*_{Ion source pulse} of the ion source pulse and a radio frequency pulse period *T*_{Radio frequency pulse} of the radio frequency pulse are 1 ms to 10 ms, and an ion source pulse duty ratio *η*_{Ion source pulse} and a radio frequency pulse duty ratio *η*_{Radio frequency pulse} are 1% to 20%.

In the example of the present disclosure, the structure of the radio frequency acceleration electrode 1501 and the structure of the quadrupole lens 1502 are the same as the structure of the radio frequency acceleration electrode and the structure of the quadrupole lens of the traditional continuous-wave high-energy ion implanter. However, since the ion source pulse 1011 of the present disclosure is the periodic pulse, a peak value of the ion beam current in the "operating" state is much higher than a peak value of the traditional continuous wave ion beam, and space charge force between ions is correspondingly increased, such that the required lateral constraint is increased. By applying the periodic pulse voltage to the lens power source of the quadrupole lens 1502, the quadrupole lens 1502 generates the periodic quadrupole lens pulses, and the pulse voltage of the periodic quadrupole lens pulse can greatly improve the peak withstand voltage limit of the quadrupole lens 1502 without changing the structure of the quadrupole lens to which the direct current high voltage is applied in the traditional continuous-wave high-energy ion implanter. Thus, a requirement for high-current transverse focusing is satisfied.

Alternatively, a traditional direct current voltage can be selected for the lens power source of the quadrupole lens 1502 considering the actual production cost.

Further, the periodic pulse applied to the quadrupole lens 1502 is synchronized with the periodic pulse of the radio frequency power source 1504 and the periodic pulse of the periodic pulsed ion source 101. That is, the lens pulse frequency *f_{lens pulse},* the ion source pulse frequency *f*_{Ion source pulse}, and the radio frequency pulse frequency *f*_{Radio frequency pulse} of the quadrupole lens pulse satisfy a relationship as follows:
${f}_{lens pulse} = {f}_{Ion source pulse} = {f}_{Radio frequency pulse} .$

In the example of the present disclosure, in a case that the radio frequency power source 1504 and the lens power source of the quadrupole lens 1502 adopt a periodic pulsed operating method, the radio frequency power sources 1504 require pulse synchronization, to make the radio frequency pulses 1507 of the radio frequency acceleration units 1503 in strict synchronization, and further requires the radio frequency sinusoidal voltage 1506 inside the pulse to be phase-locked and accurately phase-shifted, to ensure the normal radio frequency acceleration. With another application scenario as an example, the radio frequency pulse frequency *f*_{Ion source pulse}, the ion source pulse frequency *f*_{Ion source pulse}, and the lens pulse frequency *f_{lens pulse}* of the radio frequency pulse, the ion source pulse, and the quadrupole lens pulse are all 200 Hz, a corresponding radio frequency pulse period *f*_{Radio frequency pulse}, ion source pulse period *f*_{Ion source pulse}, and lens pulse period *f_{lens pulse}* are 5 ms, the radio frequency pulse duty ratio *r*_{radio frequency powqer source} is 4%, and the radio frequency pulse width *τ*_{Radio frequency pulse} is 200 *µs*. The radio frequency acceleration unit of the original continuous-wave high-energy ion implanter operating at 90 kV is now able to operate at a peak radio frequency voltage level of about 180 kV. Thus, the acceleration capability is greatly improved, while the average beam current is reduced to 4% or even less of the average beam current of the continuous wave state. In this case, the periodic pulsed ion source 101 can increase the peak plasma density inside the pulse, increase the average beam current, and reduce the implantation time. Rapid and economical implantation of the periodic pulsed high-energy ion implanter is implemented, and the time cost consumed by the machine is reduced. Alternatively, the periodic pulsed high-energy ion implanter can be applied to a production scenario of high-energy small beam, to maximize the value of the periodic pulsed high-energy ion implanter.

Further, alternatively, since there is a time difference of several *µs* between a first radio frequency acceleration unit 1503 and a last radio frequency acceleration unit 1503 when the ion beam 110 flies over the periodic pulsed radio frequency acceleration system 105, slight pulse time-delays of the radio frequency acceleration units 1503 may be set.

In the example of the present disclosure, as shown in FIG. 5, the ion beam scanning device 107 may adopt continuous scanning, and a scanning voltage is continuous and may not be interrupted. However, since a scanning period *T*_{Scanning} and the aforementioned pulse width are the same time level, in order to keep the ion implanter operating consistently constantly, avoid beam turbulence and ensure an optimal implantation effect, it is preferable that the effective operating period of the ion beam corresponds to an integer multiple of transverse scanning periods. The truly effective pulse width of the accelerated ion beam is the operating pulse width *τ*_{Overlapping} corresponding to the intersection of the flat top of the radio frequency pulse 1507 and the ion source pulse width of the ion source pulse 1101. Thus, *τ*_{Overlapping} and the scanning period *τ*_{Scanning} of the ion beam scanning device 107 satisfy a relationship as follows:
${τ}_{Overlapping} = {nT}_{Scanning} , \left(n=1,2,3,…\right) .$

In the formula, *n*=1 is easy to implement, but in order to increase beam uniformity, it is preferred that *n* ≥ 5. In addition, in order to ensure the same pace, the pulse period and the scanning period should be synchronized, and the pulse delay or the phase shift of the scanning voltage waveform can be finely adjusted. For moving components in the process chamber, it is usually necessary to coordinate with the previous periodic pulse, and the components move when the ion beam operates and stop when the ion beam stops. However, mechanical movement in a single wafer implantation mode is much slower than movement of the beam scanning (for example, the ion beam "operates" for 1 ms and "rests" for 9 ms, and the wafer moves merely below several tens of microns and far less than a beam spot diameter of several tens of millimeters in one pulse cycle). Thus, the movement of the moving components in the process chamber region merely needs to be the same as movement in the continuous-wave mode, and the synchronization problem do not need to be considered. If the wafer movement needs to be accelerated, the pulse "rest" time can also be appropriately shortened, and a compromise solution may be selected and selectively set according to the actual production demand.

If *τ*_{Overlapping} is not an integer multiple *T*_{Scannig}, and every time a batch of accelerated ion beams arrive, starting points and ending points of scanning implantation on the wafer are different since the ion beams are at different scanning voltages. Such a case is not a problem when an electric scanning speed in one dimension is quite different from a mechanical scanning speed in another dimension. Once the speed difference between the two dimensions is small, the varying starting point and ending point of each scanning may cause uneven implantation on a surface of the wafer.

Further, the ion beam of the high-energy ion implanter is pulsed and implanted into the wafer in batches. A thermal effect of wafer implantation can be reduced compared with the traditional continuous wave implantation.

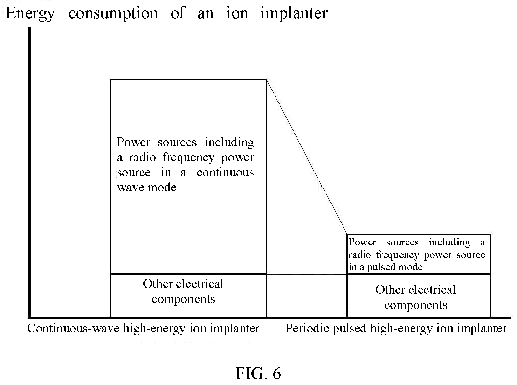

As shown in FIG. 6, the traditional continuous-wave high-energy ion implanter adopts multi-stage continuous-wave standing wave acceleration solution, and uninterrupted continuous-wave implantation makes a high-energy ion implanter become a energy-intensive apparatus. In a set of tens of kilowatts of continuous-wave high-energy ion implanter, more than a dozen radio frequency power sources operating in the continuous-wave mode occupy 60% to 90% of the power, and the power consumption of the radio frequency power sources is extremely high. In the example of the present disclosure, the radio frequency power source of the periodic pulsed high-energy ion implanters all adopt the pulsed mode, such that the power consumption of the radio frequency power source is instantly reduced, and correspondingly, the energy consumption of the complete machine is also greatly reduced. On one hand, the periodic pulsed high-energy ion implanter can achieve high-efficiency ion energy implantation without changing the structure of the complete machine and having the same energy consumption as the traditional continuous-wave high-energy ion implanter. With another application scenario as an example, the radio frequency pulse duty ratio of the radio frequency power source is 10%, and the withstand voltage of the radio frequency acceleration electrode is increased by 2 times. That is, the power of the complete machine is reduced by 5 times to 10 times, and the ion implantation energy is increased by 2 times, such that remarkable energy saving is achieved. On the other hand, in a case of the same implantation energy as the traditional continuous-wave high-energy ion implanter, the periodic pulsed high-energy ion implanter can reduce the number of the radio frequency power sources and the radio frequency acceleration units, reduce the floor space of the machine, and greatly reduce the cost of the machine.

Further, the radio frequency power source of the periodic pulsed high-energy ion implanter can continue to increase the peak power, to further increase the implantation energy.

## Claims

1. A periodic pulsed high-energy ion implanter, comprising: a periodic pulsed ion source (101), an extraction suppression electrode (102), a three-dimensional extraction electrode (103), a mass analyzer (104), a periodic pulsed radio frequency acceleration system (105), an energy analyzer (106), an ion beam scanning device (107), a beam collimating lens (108), and a process chamber (109), wherein
the periodic pulsed ion source (101) periodically generates high-density plasma, and an ion beam (110) is extracted by the extraction suppression electrode (102) and the three-dimensional extraction electrode (103), and is transmitted to the periodic pulsed radio frequency acceleration system (105) after being subjected to mass filtering by the mass analyzer (104); a pulse period of a radio frequency pulse of the periodic pulsed radio frequency acceleration system (105) is synchronized with a pulse period of an ion source pulse of the periodic pulsed ion source (101), the ion beam (110) after being subjected to the mass filtering is accelerated to a high-energy state by the periodic pulsed radio frequency acceleration system (105), and an accelerated ion beam (110) is transmitted to the energy analyzer (106) for being subjected to energy filtering; and the ion beam (110) after being subjected to the energy filtering is expanded in at least one direction by the ion beam scanning device (107), and a parallel ion beam (110) is generated by the beam collimating lens (108), and is transmitted to the process chamber (109), to complete implantation.

2. The periodic pulsed high-energy ion implanter according to claim 1, **characterized in that** the periodic pulsed radio frequency acceleration system (105) comprises a plurality of radio frequency acceleration electrodes (1501), a plurality of quadrupole lenses (1502), a plurality of radio frequency acceleration units (1503), and a plurality of radio frequency power sources (1504), and the pulse period of the radio frequency pulse of the periodic pulsed radio frequency acceleration system (105) is synchronized with the pulse period of the ion source pulse of the periodic pulsed ion source (101) as follows:
an ion source pulse frequency f_{Ion source pulse} of the ion source pulse extracted from the periodic pulsed ion source (101) through the three-dimensional extraction electrode (103), a radio frequency operating frequency *f*_{Radio frequency operating} of each radio frequency power source (1504), and a radio frequency pulse frequency *f*_{Radio frequency pulse} of a radio frequency pulse obtained through amplitude modulation from the radio frequency power source (1504) by the radio frequency acceleration electrode (1501) satisfy relationships as follows: ${f}_{Radio frequency pulse} = {f}_{Ion source pulse} ;$ and
*f*_{Radio frequency operating} » *f*_{Radio frequency pulse}.

3. The periodic pulsed high-energy ion implanter according to claim 2, **characterized in that** the ion source pulse frequency *f*_{Ion} source ₚᵤₗₛₑ, an ion source pulse width *τ*_{Ion} source ₚᵤₗₛₑ, and an ion source pulse duty ratio *η*_{Ion} source ₚᵤₗₛₑ of the ion source pulse, and the radio frequency pulse frequency *f*_{Radio frequency pulse}, a radio frequency pulse width *τ*_{Radio frequency pulse}, and a radio frequency pulse duty ratio *η*_{Radio frequency pulse} of the radio frequency pulse satisfy relationships as follows: ${η}_{Ion source pulse} = {f}_{Ion source pulse} \times {τ}_{Ion source pulse} ;$ and ${η}_{Radio frequency pulse} = {f}_{Radio frequency pulse} \times {τ}_{Radio frequency pulse} .$

4. The periodic pulsed high-energy ion implanter according to claim 3, **characterized in that** the ion source pulse and the radio frequency pulse adopt an operating mode of pulse nesting, and the ion source pulse width *τ*_{Ion} source ₚᵤₗₛₑ of the ion source pulse is nested in a flat top of the radio frequency pulse width *τ*_{Radio frequency pulse} of the radio frequency pulse.

5. The periodic pulsed high-energy ion implanter according to claim 4, **characterized in that** an operating pulse width of the periodic pulsed high-energy ion implanter is an intersection τ_{Overlapping} of a flat top of the ion source pulse width *τ*_{Ion} source ₚᵤₗₛₑ and the flat top of the radio frequency pulse width *τ*_{Radio frequency pulse}.

6. The periodic pulsed high-energy ion implanter according to claim 3, **characterized in that** ${η}_{Ion source pulse} \leq {η}_{Radio frequency pulse} .$

7. The periodic pulsed high-energy ion implanter according to claim 6, **characterized in that** a scanning period *T*_{Scanning} of the ion beam scanning device (107) and the operating pulse width τ_{Overlapping} satisfy a relationship as follows: ${τ}_{Overlapping} = {nT}_{Scanning} , \left(n=1,2,3,…\right) .$

8. The periodic pulsed high-energy ion implanter according to claim 2, **characterized in that** a voltage exerted to each quadrupole lens (1502) is a direct current voltage or a pulse voltage.

9. The periodic pulsed high-energy ion implanter according to claim 8, **characterized in that** in a case that the voltage exerted to each quadrupole lens (1502) by a lens power source is the pulse voltage, a quadrupole lens pulse on each quadrupole lens (1502) is synchronized with the radio frequency pulse and the ion source pulse; and
a lens pulse frequency *f*_{Lens pulse} of the quadrupole lens pulse, the ion source pulse frequency *f*_{Ion source pulse} of the ion source pulse, and the radio frequency pulse frequency *f*_{Radio frequency pulse} of the radio frequency pulse satisfy a relationship as follows: ${f}_{Lens pulse} = {f}_{Ion source pulse} = {f}_{Radio frequency pulse} .$

10. The periodic pulsed high-energy ion implanter according to claim 1, **characterized in that** an ion source pulse period *T*_{Ion source pulse} of the ion source pulse and a radio frequency pulse period *T*_{Radio} frequency ₚᵤₗₛₑ of the radio frequency pulse are 1 ms to 10 ms, and an ion source pulse duty ratio *η*_{Ion source pulse} of the ion source pulse and a radio frequency pulse duty ratio *η*_{Radio frequency pulse} of the radio frequency pulse are 1% to 20%.
